# EUROPEAN PATENT APPLICATION

(11) **EP 4 372 787 A1**
(43) Date of publication of application: **22.05.2024**
(21) Application number: 22207408.0
(22) Date of filing: 15.11.2022
(51) Int. Cl.: H01L 21/033, H01L 29/66

(54) **A METHOD FOR PRODUCING A PATTERN OF CLOSELY SPACED FEATURES**

(71) Applicant: Imec VZW, 3001 Leuven (BE)
(72) Inventor: CHAN, Mr. Boon Teik, 3012 Wilsele (BE); KUBICEK, Mr. Stefan, 3212 Pellenberg (BE); TAO, Mr. Zheng, 3001 Leuven (BE); LI, Mr. Waikin, 3001 Leuven (BE); LI, Mr. Ruoyu, 3000 Leuven (BE)
(74) Representative: Patent Department IMEC

(57) **Abstract**

The method applies a combination of three hardmasks (4,6,16) and depositions of masking material (5,15), together with the use of two spacers (8,18) for defining a distance between patterned features (3a-3g) down to a few nanometres. The steps of the method are configured to produce a final hardmask pattern on a target layer (3) wherein the final hardmask is subsequently transferred to the target layer in a single etching step, so that the surface onto which the target layer is formed is not affected by any process step prior to said final transfer. This ensures that the area underneath the pattern features remains unaffected by process steps such as plasma etching. The method is therefore very suitable for producing a pattern of closely spaced features which are suitable for use in a quantum dot device.

## Description

### Field of the Invention

The present invention is related to methods for patterning nanometre-sized features on a layer of material. One primary field of application is the production of closely spaced gate structures in a semiconductor quantum dot device.

### State of the art.

Quantum dot devices on semiconductor material have been explored extensively in recent years, as one of the main avenues towards realizing a workable quantum computing chip. Various architectures have been explored, which all have in common the presence of closely spaced gates configured so that quantum dots are confined underneath one or more of these gates. The gates may for example be metal gates formed on a thin layer of silicon oxide lying on a silicon substrate. By the close spacing of the gates and by applying appropriate voltages to the gates, it is possible to create quantum dots underneath the gates, i.e. small isolated electron or hole islands, at the interface between the silicon oxide and the silicon substrate, and to manipulate qubits associated with the quantum dots. The qubits may for example be defined by the spin state of individual electrons of the quantum dots. Magnetic resonance is used to control the spin states, and a read-out device, for example a single electron transistor, may be integrated in the vicinity of the quantum dot or dots. The quantum dot device is operated at a temperature of Kelvin or sub-Kelvin range (i.e. about 1K or less) in order to enable sufficient qubit coherence times and qubit-based computations.

One recurring problem common to various configurations which answer to the above description is related to the manufacturing process for realizing the closely spaced and nano-scaled gate array. The gate widths are required to be in the range of a few tens of nanometres while the dielectric spacing between the gates must be as small as possible, preferably around 10 to 20 nm or even lower. Currently applied methods for producing such a structure include the use of consecutive gate patterning steps resulting in partly overlapping gates, or the use of techniques similar to multiple patterning. This approach however results in non-uniform dielectric spacing between the gates and in non-uniform gate heights, which may be detrimental for the device operation.

Quantum dot devices may include additional structures such as confinement electrodes spaced apart from the gate array by dielectric-filled spacings of the same order of magnitude as the inter-gate spacing and oriented transversally to said inter-gate spacing. These transversally oriented spacings are also non-uniform and therefore difficult to control using currently applied fabrications methods.

A problem that is common to all currently applied methods is the fact that the substrate onto which the gates are formed is exposed once or multiple times to plasma etching during the fabrication process. Such exposure is likely to damage the substrate resulting in a deterioration of the interface quality, thereby degrading the qubit performance.

### Summary of the invention

The invention aims to provide a patterning method that enables to produce closely spaced nanometre-sized features without exposing an underlying substrate to plasma etching. This aim is achieved by a method as disclosed in the appended claims. Embodiments of the method apply a combination of three hardmasks and depositions of masking material, together with the use of two spacers for defining a distance between patterned features down to a few nanometres, in two transverse directions. The steps of the method are configured to produce a final hardmask pattern on a target layer wherein the final hardmask is subsequently transferred to the target layer in a single etching step, so that the surface onto which the target layer is formed is not affected by any process step prior to said final transfer. This ensures that the area underneath the pattern features remains unaffected by process steps such as plasma etching. The method is therefore very suitable for producing a pattern of closely spaced structures which are suitable for use in a quantum dot device.

The invention is in particular related to a method for patterning a target layer according to a pattern comprising a plurality of closely spaced features, the method comprising the steps of:
- producing a first patterned hardmask on the target layer, the first patterned hardmask comprising two blocks having mutually facing sidewalls spaced apart by a gap,
- producing a pair of first spacers respectively on the sidewalls of the blocks of the first hardmask,
- thereafter, depositing a first layer of masking material on the target layer and planarizing said layer of masking material and said blocks, so as to obtain a common planarized surface,
- producing a second patterned hardmask on said planarized surface, the second patterned hardmask comprising two or more spaced-apart and mutually parallel blocks oriented transversely relative to the spaced-apart blocks of the first hardmask and covering at least the gap between the spacers on the mutually facing sidewalls of said blocks of the first hardmask,
- removing said first layer of masking material relative to the second patterned hardmask, relative to the blocks of the first patterned hardmask and relative to the first spacers, so that a plurality of first blocks of masking material remain between the blocks of the first hardmask, wherein the first blocks of masking material are separated from the blocks of the first hardmask by the first spacers,
- removing the second hardmask,
- removing the first spacers selectively relative to the blocks of the first hardmask and relative to the first blocks of masking material, so that after the removal of the first spacers, the first blocks of masking material are spaced apart from the blocks of the first hardmask,
- producing a second spacer on the exposed portions of the side surfaces of the blocks of the first hardmask and of the plurality of first blocks of masking material, so that the second spacer fills the spaces between the first blocks of masking material and the blocks of the first hardmask,
- depositing a second layer of masking material on the target layer and planarizing said second layer, the blocks of the first hardmask and the plurality of first blocks of masking material so as to obtain a common planarized surface,
- producing a third patterned hardmask on the planarized surface obtained in the previous step, the third patterned hardmask comprising a block that covers at least said plurality of first blocks of masking material,
- removing the second layer of masking material relative to the third hardmask, so that one or more second blocks of masking material remain, said second blocks being separated from the first blocks of hardmask material and from the blocks of the first hardmask by the second spacer
- removing the third hardmask,
- selectively removing the second spacer relative to the blocks of the first hardmask and to the first and second blocks of masking material, to thereby obtain a final patterned hardmask, comprising the blocks of the first hardmask and the first and second blocks spaced apart in one or the other of two transverse directions by spacings corresponding to the first spacers or the second spacer,
- transferring the pattern of said final hardmask to the target layer by removing the material of the target layer relative to the final hardmask, wherein the transfer of the blocks of the first hardmask and of the first and second blocks of masking material results in the formation of said plurality of closely spaced features,
- removing the final hardmask.

According to an embodiment, the width of the first spacers and second spacer is between 5 and 20 nm.

According to an embodiment, the width of the first spacers and of the second spacer is the same.

According to an embodiment, the blocks of the first hardmask have mutually facing sidewalls which are mutually parallel.

According to an embodiment, the blocks of the first hardmask are mutually parallel square or rectangular blocks as seen in the plane of the target layer.

According to an embodiment, the first and second layers of masking material are layers formed of SiO₂.

According to an embodiment, the final pattern is configured to produce a plurality of closely spaced structures of a quantum dot device, by performing a gate replacement technique on the patterned target layer.

According to an embodiment, the target layer is a semiconductor layer overlying a dielectric layer. The semiconductor layer may be a layer of polycrystalline silicon or a layer of amorphous silicon, and the dielectric layer may be a layer of silicon oxide.

### Brief description of the figures

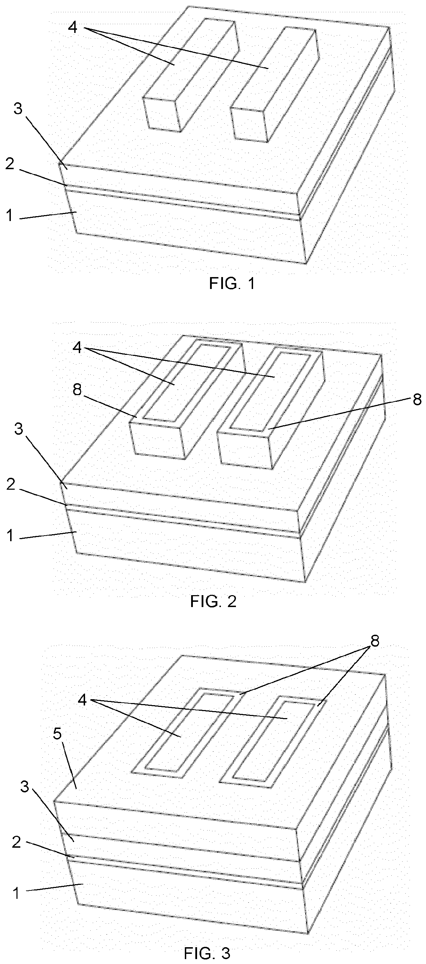

Figures 1 to 15 illustrate the steps of the method according to an embodiment of the invention.

### Detailed description of embodiments of the invention

Figures 1 to 15 illustrate an embodiment of the method of the invention which will be described hereafter in detail. The materials and dimensions stated throughout the detailed description are given purely by way of example and are not limiting the scope of the invention.

Figure 1 is a 3D view of a small area of a silicon substrate 1, which may be a standard silicon process wafer of 200 mm or 300 mm in diameter and of several hundreds of micrometres in thickness. On the surface of the Si wafer is a thin silicon oxide (SiO₂) layer 2 having a thickness in the order of 5 to 10 nm. Directly on the SiO₂ layer 2 is a layer 3 of polycrystalline silicon (polySi) having a thickness between 20 nm and 50 nm. Methods for producing the SiO₂ layer 2 and the polySi layer 3 on the Si wafer 1 are well-known and are therefore not described here. The target layer 3 may be formed of any suitable material other than polySI. Instead of a polySi layer, layer 3 could for example be a layer of amorphous silicon of similar thickness.

Layer 3 plays the part of the 'target layer' stated in the appended claims. The aim of the method is to pattern the target layer 3 so as to create closely spaced areas which will be suitable to be used as dummy structures in a standard replacement gate technique for producing metal gates and laterally placed structures such as confinement electrodes on the SiO₂ layer 2.

As shown in Figure 1, a first patterned lithographic hardmask 4 is formed on the target layer 3. This may be done by lithography and etching steps known as such. In the embodiment shown, the pattern comprises two rectangular beam-shaped blocks 4 formed of a single material, for example silicon nitride (hereafter abbreviated as SiN, but intended to refer to the compound Si₃N₄ and possible stoichiometric variations thereof) or titanium nitride (TiN). The blocks could however also be formed as stacks of layers of different materials. The blocks 4 are oriented parallel to each other and spaced apart by a distance of about 50 nm. The length of the blocks is about 100 nm. The invention is however not limited to these dimensions, nor to blocks of rectangular shape, nor to parallel rectangular blocks.

As illustrated in Figure 2: after the formation of the blocks 4, a pair of spacers 8 is formed respectively on the sidewalls of the two blocks 4. The width of the spacers 8 may for example be about 10nm. This can be realized by depositing a layer of SiN conformally on the blocks 4, i.e. a layer that follows the topology of the blocks, followed by etching back the SiN layer so that it is removed from the horizontal surfaces of the structure and from the surface of the polySi layer 3, while maintaining it on the vertical sidewalls of the blocks 4. This can be done by a dry etching technique using plasma etching. Ample knowledge about such etch recipes is available in the art, therefore a precise description of such etch recipes is not needed here. The thickness of the conformally applied SiN layer and the etch parameters are controlled in such a manner that a spacer width of about 10nm is obtained. The spacers 8 in Figure 2 are shown to have upper surfaces which are level with the upper surface of the blocks 4. In reality, the upper surface of the spacer 8 is likely to be slightly curved downward relative to the upper surface of the blocks 4 as a consequence of the dry etch process. Such details are however also well-known, and the drawing is merely intended to illustrate the location and width of the spacer 8.

Next, as illustrated in Figure 3, a first layer 5 of masking material is deposited and planarized so that the upper surfaces of the layer 5 and of the blocks 4 are coplanar. In the image, the spacers 8 are equally planarized to the same level as the blocks 4 and the layer 5, but it is possible that the curved upper portion of the spacers referred to above is not entirely removed by the planarization so that said curved upper portion of the spacers (or a remaining portion thereof) is slightly below the planarized surface. It is correct to say therefore that at least the blocks 4 and the layer 5, and possibly also the spacers 8, are planarized to a common level surface. In the particular embodiment described here, layer 5 is a layer of SiO₂, but other materials are possible. The term 'masking material' is used here because the material of this layer will eventually contribute to the definition of a final patterned hardmask, the pattern of which will be transferred into the polySi layer 3 in one of the final steps of the method.

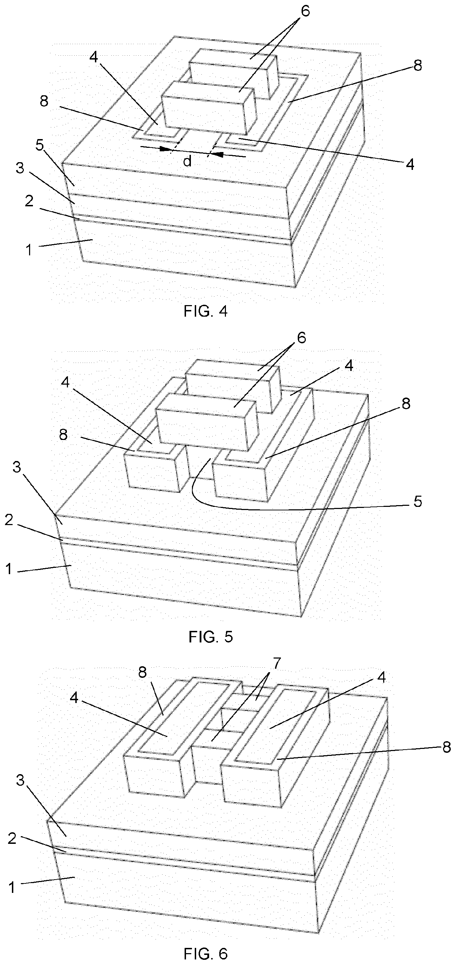

Following the formation of the SiO₂ layer 5, a second patterned hardmask 6 is formed on the planarized surface, as illustrated in Figure 4. This may be done by a lithography and etch process as generally known in the art. The second hardmask comprises again two rectangular and mutually parallel blocks 6. The blocks 6 are spaced apart by about 40 nm. The width of the blocks 6 is also about 40nm. The blocks 6 of the second hardmask are covering the gap d (see Fig. 4) between the spacers 8 on the mutually facing surfaces of the blocks 4 of the first hardmask. The material of the second hardmask 6 is different from the material of the first hardmask 4, in order to ensure a good etch selectivity in the lithography and etch process applied for forming the second blocks 6. For example, when the first hardmask 4 is formed of SiN or TiN, the second hardmask 6 could be formed of amorphous carbon. In the embodiment shown, the second hardmask comprises two blocks 6, but this number could be higher depending on the required layout. The main requirement for the position of the second hardmask relative to the first hardmask is that the blocks 6 of the second hardmask are fully covering the gap d. The length of the blocks 6 can be chosen sufficiently long so that the overlay accuracy applicable for the formation of the second hardmask can be quite relaxed.

With reference to Figure 5, the planarized SiO₂ layer 5 is then removed by essentially anisotropic etching relative to the second hardmask 6 and relative to the blocks 4 of the first hardmask. In other words, only the portions of said SiO₂ layer 5 directly underneath the blocks 6 of the second hardmask remain, while the exposed parts of said layer 5 are removed. This can be done by an etch recipe that removes SiO₂ selectively with respect to the materials of the first and second hardmasks.

The second hardmask 6 is then removed while maintaining the first hardmask 4, resulting in the structure shown in Figure 6. Removal of the second hardmask may be done by a dry or wet etch process known as such in the art. The blocks 4 of the first hardmask are still present, and two blocks 7 of SiO₂ are bridging the gap d between the mutually facing spacers 8. The wording essentially anisotropic etching' means that a small degree of isotropic etching is allowable, as long as clearly defined blocks 7 remain having sidewalls at an essentially right angle with the surface of layer 3, after the removal of the second hardmask 6.

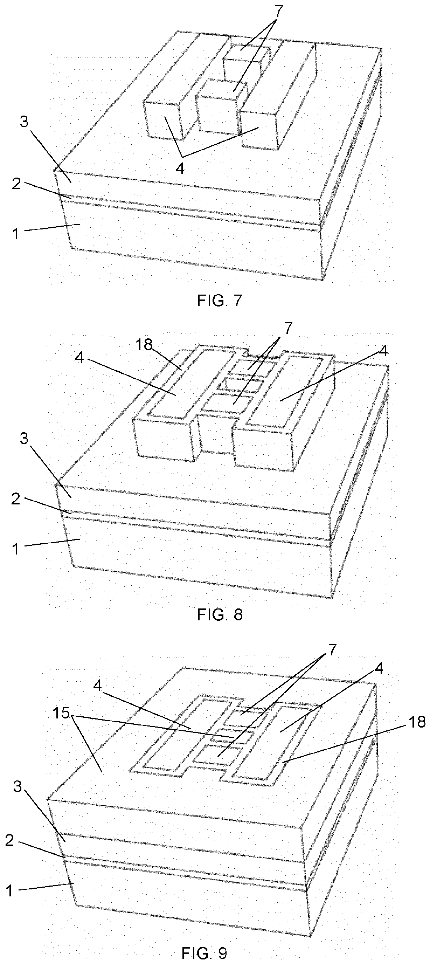

Thereafter, the spacers 8 are removed selectively with respect to the blocks 4 of the first hardmask, and with respect to the SiO₂ blocks 7. The result of this step is shown in Figure 7. The SiO₂ blocks 7 are spaced apart from the first hardmask blocks 4 by a spacing that corresponds to the width of the spacers 8.

After this, a second spacer 18 is formed on the sidewalls of the remaining structures, as illustrated in Figure 8. The spacings between the SiO₂ blocks 7 and the blocks 4 of the first hardmask are filled with the spacer material of the second spacer 18. It is seen that the spacer 18 has the same width as the first spacers 8. This is not a strict requirement of the invention, and the spacers may have different thicknesses. However, in order for the gap between the SiO₂ blocks 7 and the blocks 4 of the first hardmask to be completely filled with spacer material, the second spacer 18 needs to have at least ½ the thickness of the first spacers 8. This is because the spacer material is formed progressively on the exposed surfaces, so also on the sidewalls of the blocks 7 and 4 on both sides of the gap. So for the gap to be closed by the spacer material, the thickness of the second spacer 18 needs to be at least half the width of the gap. This gap width is however the same as the width of the first spacers 8, hence the second spacer 18 must be at least half as thick as the first spacers 8. When the second spacer 18 is thicker than ½ of the thickness of the first spacers, as is the case in the drawing, spacer material is likely to be pushed upwards out of the gap. This is not shown in Figure 8. The material that is pushed out of the gap will however be removed at least partially by etching back the conformally applied spacer material and fully by a planarization step that will be performed later in the process, as explained in the next paragraph. As stated in relation to the first spacers 8, the spacer 18 may have a curved upper portion that is not represented in the drawing.

The next step, illustrated in Figure 9, consists in the deposition of another layer 15 of masking material, which may again be SiO₂, followed by the planarization of said layer 15, the blocks 4 of the first hardmask and the SiO₂ blocks 7 so as to obtain a common planarized surface. As in the case of the spacers 8, the spacer 18 may be planarized to the same level as the blocks 4 and the layer 5, but it is possible that the curved upper portion of the spacer 18 is not entirely removed by the planarization so that said curved upper portion of the spacers (or a remaining portion thereof) is slightly below the planarized surface.

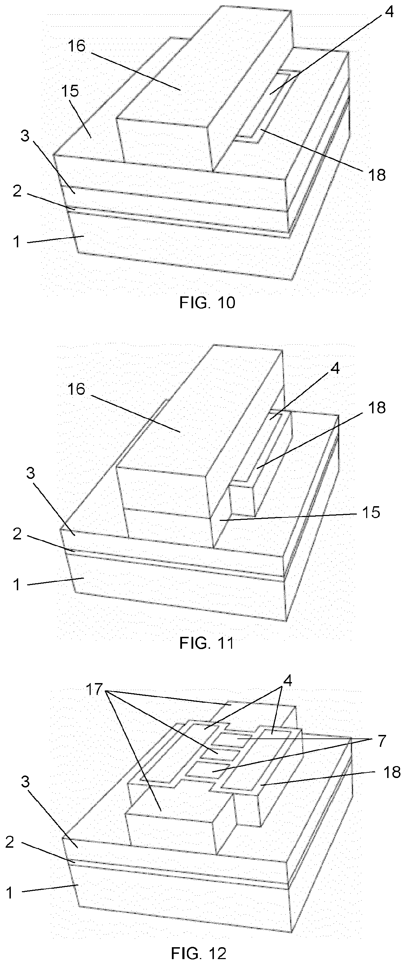

Then a third patterned hardmask 16 is produced on the planarized surface, as illustrated in Figure 10. This may be done by a standard lithography and etch process. The third hardmask 16 is formed of a material that is different from the first hardmask 4 and from the second spacer 18. For example, when the first hardmask 4 and the second spacer 18 are formed of SiN, the third hardmask 16 may be formed of amorphous carbon. This is to ensure etch selectivity in the etch process for forming the mask 16. The third hardmask comprises a block 16 that covers at least the blocks 7. Preferably, and as illustrated in Figure 10, the block 16 covers at least part of the blocks 4 of the first hardmask. The overlay accuracy for the formation of the third hardmask 16 can once again be quite relaxed as there are no strict requirements as to the width of the block 16, apart from the requirement that it must cover at least the blocks 7.

The SiO₂ layer 15 is then etched essentially anisotropically relative to the third hardmask 16, and relative to the spacer 8 and the blocks 4 of the first hardmask, as illustrated in Figure 11. After that, the third hardmask 16 is removed, resulting in the image shown in Figure 12. In addition to the blocks 7, three additional blocks 17 of SiO₂ have been formed, one central block that is fully surrounded by the spacer 18, and two lateral blocks.

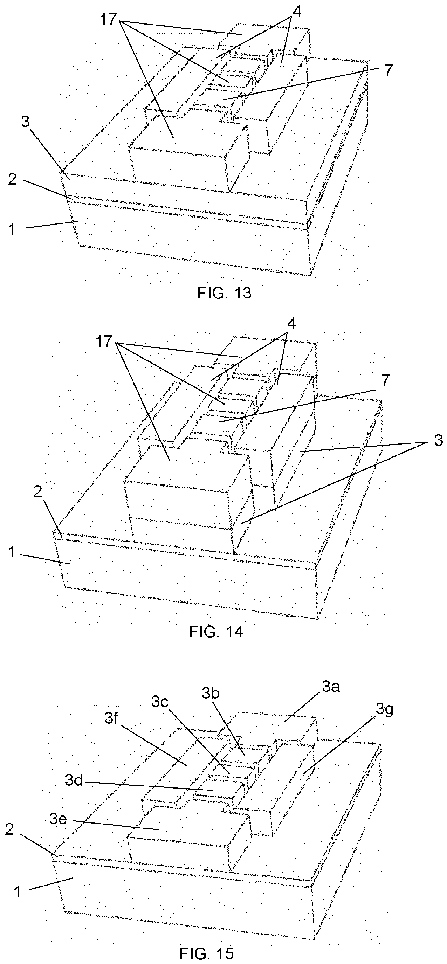

The next step is the selective removal of the spacer 18 relative to the SiO₂ blocks 7 and 17 and relative to the blocks 4 of the first hardmask, resulting in the structures shown in Figure 13.

The blocks 4 of the first hardmask and the remaining SiO₂ blocks 7 and 17 are now forming a final patterned hardmask directly on the polySi target layer 3. Said polySi layer is then etched essentially anisotropically relative to this SiO₂ hardmask, i.e. the pattern of the blocks 4 and SiO₂ blocks 7 and 17 is transferred to the polySi layer 3, as illustrated in Figure 14. Finally, the blocks 4 and the SiO₂ blocks 7 and 17 are removed, leaving the patterned polySi layer 3 as shown in Figure 15. The pattern comprises an array of closely spaced polySi areas 3a to 3e, spaced apart by the width of the first spacer 8, i.e. by about 10nm. It is therefore the width of the first spacer 8 that defines the spacing between the polySi areas 3a to 3e. As the width of the spacer can be controlled down to values of a few nm, the method enables to produce closely spaced structures, spaced apart by said very small spacings, without however encountering the problems of prior art methods described in the introduction.

The blocks 4 of the first hardmask have been transferred as well, forming areas 3f and 3g of polySi on both sides of the array of polySi areas 3a to 3e and spaced therefrom by about 10 nm.

The spaces between the polySi areas 3a to 3g may now be filled with a dielectric, after which the structure may be processed by a standard gate replacement technique, replacing the polySi areas 3a to 3g by metal structures. At least the metal structures which replace the structures 3b, 3c and 3d may serve as metal gates in a quantum dot device, with the outer structures 3a and 3e possibly acting as source and drain of the device. The metal structures obtained in the location of the larger polySi areas 3f and 3g can act as metal confinement electrodes of the quantum dot device. Such electrodes need to be as closely spaced from the gate array as the gates are separated from each other. Producing such a configuration without exposing the SiO₂ layer to plasma etching is enabled by the invention, which is characterized by the fact that two spacers 8 and 18 are deposited in the course of the process, resulting in very small spacings in two transverse directions.

As stated, the width of the first spacers 8 and the second spacer 18 need not be the same, but different spacers widths could be applied according to a desired layout.

From the above description, it is clear that the SiO₂ layer 2 underneath the polySi target layer 3 is never exposed to any of the process steps before the transfer of the final SiO₂ hardmask pattern 4/7/17 to the polySi layer 3. In other words, the pattern of the closely spaced areas is transferred to said polySi layer in one etch step, so that the SiO₂ underneath the areas is not affected by plasma etching. This represents the main advantage of the method of the invention over prior art methods. Damage of the SiO₂ layer 2 by plasma etching is excluded when the method of the invention is applied. Such damage would negatively affect the interface between the SiO₂ layer 2 and the Si substrate 1, thereby degrading the qubit performance of a quantum dot device formed on said interface.

A further advantage is that because of the fabrication by a single etch step, the dielectric spacings between the various structures are uniform along the full height of these structures.

The connection of the all or a number of the metal areas 3a to 3g to specific voltages in accordance with a given quantum dot device layout may be realized by methods known as such in semiconductor processing.

The invention is however not limited to the production of quantum dot devices, but may be applicable in the fabrication process of other devices comprising a layout of closely spaced features similar to the layout shown in the drawings.

While the invention has been illustrated and described in detail in the drawings and foregoing description, such illustration and description are to be considered illustrative or exemplary and not restrictive. Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

## Claims

1. A method for patterning a target layer (3) according to a pattern comprising a plurality of closely spaced features (3a-3g), the method comprising the steps of:
- producing a first patterned hardmask on the target layer (3), the first patterned hardmask comprising two blocks (4) having mutually facing sidewalls spaced apart by a gap,
- producing a pair of first spacers (8) respectively on the sidewalls of the blocks (4) of the first hardmask,
- thereafter, depositing a first layer (5) of masking material on the target layer (3) and planarizing said layer of masking material and said blocks (4), so as to obtain a common planarized surface,
- producing a second patterned hardmask on said planarized surface, the second patterned hardmask comprising two or more spaced-apart and mutually parallel blocks (6) oriented transversely relative to the spaced-apart blocks (4) of the first hardmask and covering at least the gap (d) between the spacers (8) on the mutually facing sidewalls of said blocks (4) of the first hardmask,
- removing said first layer of masking material (5) relative to the second patterned hardmask (6), relative to the blocks (4) of the first patterned hardmask and relative to the first spacers (8), so that a plurality of first blocks (7) of masking material remain between the blocks (4) of the first hardmask, wherein the first blocks (7) of masking material are separated from the blocks (4) of the first hardmask by the first spacers (8),
- removing the second hardmask (6),
- removing the first spacers (8) selectively relative to the blocks (4) of the first hardmask and relative to the first blocks (7) of masking material, so that after the removal of the first spacers (8), the first blocks (7) of masking material are spaced apart from the blocks (4) of the first hardmask,
- producing a second spacer (18) on the exposed portions of the side surfaces of the blocks (4) of the first hardmask and of the plurality of first blocks (7) of masking material, so that the second spacer (18) fills the spaces between the first blocks (7) of masking material and the blocks (4) of the first hardmask,
- depositing a second layer (15) of masking material on the target layer (3) and planarizing said second layer, the blocks (4) of the first hardmask and the plurality of first blocks (7) of masking material so as to obtain a common planarized surface,
- producing a third patterned hardmask on the planarized surface obtained in the previous step, the third patterned hardmask comprising a block (16) that covers at least said plurality of first blocks (7) of masking material,
- removing the second layer (15) of masking material relative to the third hardmask (16), so that one or more second blocks (17) of masking material remain, said second blocks (17) being separated from the first blocks (7) of hardmask material and from the blocks (4) of the first hardmask by the second spacer (18)
- removing the third hardmask (16),
- selectively removing the second spacer (18) relative to the blocks (4) of the first hardmask and to the first and second blocks (7,17) of masking material, to thereby obtain a final patterned hardmask, comprising the blocks (4) of the first hardmask and the first and second blocks (7,17) spaced apart in one or the other of two transverse directions by spacings corresponding to the first spacers (8) or the second spacer (18),
- transferring the pattern of said final hardmask to the target layer (3) by removing the material of the target layer (3) relative to the final hardmask, wherein the transfer of the blocks (4) of the first hardmask and of the first and second blocks (7,17) of masking material results in the formation of said plurality of closely spaced features (3a-3g),
- removing the final hardmask.

2. The method according to claim 1, wherein the width of the first spacers (8) and second spacer (18) is between 5 and 20 nm.

3. The method according to claim 1 or 2, wherein the width of the first spacers (8) and of the second spacer (18) is the same.

4. The method according to any one of the preceding claims, wherein the blocks (4) of the first hardmask have mutually facing sidewalls which are mutually parallel.

5. The method according to claim 4, wherein the blocks (4) of the first hardmask are mutually parallel square or rectangular blocks as seen in the plane of the target layer (3).

6. The method according to any one of the preceding claims, wherein the first and second layers (5,15) of masking material are layers formed of SiO₂.

7. The method according to any one of the preceding claims, wherein the final pattern is configured to produce a plurality of closely spaced structures of a quantum dot device, by performing a gate replacement technique on the patterned target layer.

8. The method according to claim 7, wherein the target layer is a semiconductor layer (3) overlying a dielectric layer (2).

9. The method according to claim 8, wherein the semiconductor layer (3) is a layer of polycrystalline silicon or a layer of amorphous silicon, and wherein the dielectric layer (2) is a layer of silicon oxide.
